Europäisches Patentamt

European Patent Office

Office européen des brevets

(19)

(11) Veröffentlichungsnummer: **0 239 140 B1**

# (12) EUROPÄISCHE PATENTSCHRIFT

(45) Veröffentlichungstag der Patentschrift:
07.08.91 Patentblatt 91/32

(51) Int. Cl.$^5$: **C30B 23/02, C30B 29/28**

(21) Anmeldenummer: 87200262.1

(22) Anmeldetag: 18.02.87

(54) **Verfahren zur Herstellung von strukturierten epitaxialen Schichten auf einem Substrat.**

(30) Priorität: 22.02.86 DE 3605793

(43) Veröffentlichungstag der Anmeldung:
30.09.87 Patentblatt 87/40

(45) Bekanntmachung des Hinweises auf die
Patenterteilung:
07.08.91 Patentblatt 91/32

(84) Benannte Vertragsstaaten:
DE FR GB NL

(56) Entgegenhaltungen:
EP-A- 0 146 985
EP-A- 0 167 213
US-A- 3 928 092
US-A- 4 290 843

(73) Patentinhaber: Philips Patentverwaltung
GmbH
Wendenstrasse 35 Postfach 10 51 49
W-2000 Hamburg 1 (DE)
DE
Patentinhaber: N.V. Philips'
Gloeilampenfabrieken
Groenewoudseweg 1
NL-5621 BA Eindhoven (NL)
FR GB NL

(72) Erfinder: Doormann, Volker
Borchertring 27
W-2000 Hamburg 60 (DE)
Erfinder: Krumme, Jens-Peter, Dr.
Heydornweg 4
W-2000 Hamburg 55 (DE)

(74) Vertreter: Nehmzow-David, Fritzi-Maria et al
Philips Patentverwaltung GmbH
Wendenstrasse 35 Postfach 10 51 49
W-2000 Hamburg 1 (DE)

**Beschreibung**

Die Erfindung betrifft ein Verfahren zur Herstellung von strukturierten epitaxialen Schichten, bei denen einkristalline Schichtbereiche benachbart neben Schichtbereichen anderer Ordnung auf einem einkristallinen Substrat vorhanden sind, dessen Kristallgitter in örtlich begrenzten Oberflächenbereichen unter Ausbildung einer Gitterfehlordnung gestört ist.

Die Erfindung betrifft weiter die Verwendung nach einem derartigen Verfahren hergestellter Schichten.

Bei der Herstellung z.B. elektronischer Bauelemente, wie Halbleiterbauelemente, oder z.B. magneto-optischer Bauelemente, wie magneto-optische Lichtschaltelemente, Zylinderdomänenspeicher oder magneto-optische Isolatoren, wird von epitaktisch auf einkristallinen Substraten gezüchteten einkristallinen Schichten ausgegangen, die, entsprechend dem Anwendungszweck, strukturiert werden müssen, bevor sie den weiteren Bearbeitungsschritten unterzogen werden. Unter Struktuierung ist die örtliche Unterteilung der einkristallinen Schicht zu verstehen, wobei z.B. durch einen naßchemischen Ätzprozeß einkristalline Inseln aus der epitaxialen Schicht geätzt werden, die getrennt voneinander auf dem durchgehenden, einkristallinen Substrat vorhanden sind.

Die Strukturierung einkristalliner Schichten durch einen naßchemischen Ätzprozeß führt unter Entfernung eines Teils der zunächst das gesamte Substrat bedeckenden einkristallinen Schicht zu voneinander getrennten einkristallinen Bereichen auf dem durchgehenden Substrat. Für nachfolgende Prozeßschritte kann es nun von Nachteil sein, daß die ehemals planare Oberfläche der einkristallinen Schicht infolge der Strukturierung mittels des naßchemischen Ätzprozesses nicht mehr planar ist. Es ist versucht worden (Jap. J. Appl. Phys. 16 (1977), Nr. 2, Seiten 373 bis 374), eine Strukturierung von z.B. durch Flüssigphasenepitaxie herzustellenden Schichten dadurch zu bewirken, daß das Substrat vor Anbringen der epitaxialen Schicht örtlich mittels Implantation energetischer Ionen gestört wird, so daß bei der epitaxialen Schichtabscheidung ein Muster aus epitaxialen, also einkristallinen Gebieten (Schicht auf ungestörten Substratbereichen) in einer polykristallinen Umgebung (Schicht auf gestörten Substratbereichen) entsteht. Die Energie der zu implantierenden Ionen in der Größenordnung von $10^4$ eV ist dabei so niedrig zu halten, daß noch alle Ionen von der Maske absorbiert werden, sie ist aber so hoch zu wählen, daß die Tiefe der Störungen im Substrat durch implantierte Ionen ausreicht, um während des in der Anfangsphase der Flüssigphasenepitaxie auftretenden Anätzens des Substrates nicht völlig aufgezehrt zu werden. Diese Bedingungen setzen Grenzen in der Maskentechnologie und bedeuten vor allem einen großen technischen Aufwand, da eine Ionenimplantationsanlage eingesetzt werden muß. Um die einkristallinen epitaxialen Bereiche herum entstehen auf den gestörten Bereichen des Substrates polykristalline Randzonen, die unerwünscht sein können ;

z.B. sind diese polykristallinen Bereiche bei mittels Flüssigphasenepitaxie abgeschiedenen ferrimagnetischen Granatschichten ebenfalls magnetisch, was z.B. für einen einwandfreien magneto-optischen Schaltprozeß bei Lichtschaltelementen nachteilig sein kann. Außerdem ist es bei Bauelementen auf Basis von magnetischen einkristallinen Schichten, die von polykristallinen Randzonen umgeben sind, nachteilig, daß die Führung und die Bildung magnetischer Wände in ungewünschter Weise beeinflußt werden. Magnetische Wände werden an den relativ rauhen Grenzflächen (interfaces) zwischen den polykristallinen und einkristallinen Bereichen festgehalten.

Es ist anzumerken, daß aus EP-A 167 213 ein Verfahren zur Herstellung nicht strukturierter, einkristalliner, Wismutsubstituierter ferrimagnetischer Granatschichten durch HF-Kathodenzerstäubung bekannt war, wobei bei Benutzung von Targets, in denen Wismut nicht als $Bi_2O_3$ sondern beispielsweise als $BiFeO_3$ vorliegt, bei Substrattemperaturen von 300 bis 650 °C unter Verwendung von einkristallinen Gadolinium-Gallium-Granat-Einkristallscheiben oder von Platten aus Gläsern röntgenamorphe Wismut-substituierte Eisengranatschichten abgeschieden werden, die durch Erhitzen bei 730 °C bei Verwendung von einkristallinen Granatsubstraten bzw. bei 780 °C bei Verwendung von Glassubstraten in Kristallform umgewandelt werden.

Der Erfindung liegt die Aufgabe zugrunde, das eingangs genannte Verfahren derart zu verbessern, daß strukturierte epitaxiale Schichten quasi planar mit geringerem apparativen Aufwand und mit glatten Grenzflächen zwischen den epitaxialen und den sie umgebenden Randzonen anderer Ordnung hergestellt werden können.

Diese Aufgabe wird erfindungsgemäß dadurch gelöst, daß die Schichten mittels HF-Kathodenzerstäubung (Sputterepitaxie) in einem Inertgasplasma unter Verwendung eines die am Schichtaufbau beteiligten Elemente in Form von Phasen mit nahezu gleicher Zerstäubungsrate enthaltenden Targets hergestellt werden, wobei das Substrat auf eine Temperatur aufgeheizt wird, die höher ist, als die Temperatur, bei der epitaxiales Schichtwachstum auf Substratbereichen mit ungestörtem Kristallgitter beginnt, und die niedriger ist, als die Temperatur, bei der polykristallines Schichtwachstum auf Substratbereichen mit gestörtem Kristallgitter beginnt und wobei die Gitterstruktur des Substrates bis in einige Atomlagen Tiefe durch Ionenbeschuß mittels eines Plasmas örtlich gestört wird.

2

Der Erfindung liegt die Erkenntnis zugrunde, daß Sputterepitaxie von z.B. komplex zusammengesetzten Schichten, die aus Elementen sehr voneinander abweichender Zerstäubungsrate bestehen, realisiert werden kann, wenn einkristalline Substrate mit gut definierten, ungestörten Oberflächen und wenn Targets mit Phasen nahezu gleicher Zerstäubungsrate eingesetzt werden und wenn der HF-Kathodenzerstäubungsprozeß in einem Inertgasplasma, vorzugsweise einem Edelgasplasma, unter Einsatz vorzugsweise einer Magnetronelektrode durchgeführt wird.

Bei einem Sputterepitaxieprozeß spielt die Temperatur des Substrates während des Abscheidungsprozesses eine Rolle : eine höhere Substrattemperatur begünstigt eine spontane Kristallisation der abgeschiedenen Schicht, wobei nun gefunden wurde, daß epitaxiales Wachstum auf Substratbereichen mit ungestörtem Kristallgitter bei niedrigeren Temperaturen einsetzt, als polykristallines Wachstum auf Substratbereichen mit gestörtem Kristallgitter. Es bedeutet also, daß

$T_{\text{epitaktisches Wachstum}} < T_{\text{polykristallines Wachstum}}$ ist. Diese Temperaturen werden im folgenden als $T_{epi}$ bzw. $T_{poly}$ bezeichnet. Werden Substrate eingesetzt, deren Kristallgitter örtlich z.B. durch Ionenbeschuß in einen Fehlordnungszustand überführt wurden, wird auf den gestörten Substratbereichen je nach Höhe der Substrattemperatur eine amorphe oder eine polykristalline Schicht durch den Kathodenzerstäubungsprozeß abgeschieden, wogegen auf den ungestörten, einkristallinen Bereichen das durch Kathodenzerstäubung abgeschiedene Material einkristallin aufwächst. Für die zu wählende Substrattemperatur T bei der Herstellung einer strukturierten Schicht mit einkristallinen und benachbarten amorphen Schichtbereichen mittels Sputterepitaxie gilt also :

$T_{epi} < T_{Substrat} < T_{poly}$.

Es hat sich bei der Herstellung ferrimagnetischer Granatschichten nun gezeigt, daß diese Schichten auf einkristallinen Granat-Substraten einkristallin aufwachsen, wenn die Substrate auf eine Temperatur von $\approx$ 450°C aufgeheizt werden.

Werden ferrimagnetische Granatschichten auf zumindest in oberflächennahen Bereichen nicht-einkristallinen Substraten, wie z.B. gestörten einkristallinen, oder auf polykristallinen oder amorphen Substraten abgeschieden, bilden sich bei einer Substrattemperatur unter 520°C amorphe bis röntgenamorphe Schichten und bei höheren Substrattemperaturen polykristalline Schichten.

Die Gitterstruktur des Substrates wird bis in einige Atomlagen Tiefe durch Ionenbeschuß mittels eines Plasmas, vorzugsweise eines Edelgasplasmas, gestört.

Ein Sputterätzprozeß (Ionenbeschuß aus dem Plasma) bei relativ kleinen HF-Spannungen und bei relativ kleinen Drucken des Plasmas reicht dazu aus, ein mittels Kathodenzerstäubung epitaktisch zu beschichtendes einkristallines Substrat in oberflächennahen Bereichen einer Tiefe von nur wenigen Atomlagen so in seiner Gitterstruktur zu stören, daß in Abhängigkeit von der Substrattemperatur in gestörten Bereichen keine epitaxiale sondern eine Schicht anderer Ordnung, vorzugsweise eine amorphe Schicht aufwächst neben einer epitaxialen Schicht auf den ungestörten Bereichen des Substrates. Hiermit ist der Vorteil verbunden, daß mit ein und derselben Vorrichtung während des gesamten Prozesses gearbeitet werden kann und daß eine Gitterstörung erreicht wird von nur einigen Atomlagen Tiefe.

Nach einer vorteilhaften weiteren Ausbildung der Erfindung werden strukturierte einkristalline ferrimagnetische Granatschichten der allgemeinen Formel $(A,B)_3 (A,B)_5 O_{12}$ hergestellt mit A = mindestens ein Seltenerdmetall, Bi und/oder Ca und B = Ga,Al,Fe,Co,Ni,Mn,Ru,Ir,In und/oder Sc. Da der Sputterepitaxieprozeß im Gegensatz zu z.B. Flüssigphasenepitaxieprozessen außerhalb des thermo-chemischen Gleichgewichtes verläuft, ist die Herstellung von z.B. Granatschichten in Nicht-Gleichgewichtszusammensetzungen ohne Fremdphase möglich. Es wurden z.B. einphasige ferrimagnetische Granatschichten mit folgenden Zusammensetzungen hergestellt :

1. $Gd_{1,97}Bi_{1,04}Fe_{4,51}Ga_{0,22}Al_{0,26}O_{12}$ oder

2. $Gd_{1,90}Bi_{1,45}Fe_{4,09}Al_{0,34}Ga_{0,22}O_{12}$.

Nach einer vorteilhaften weiteren Ausgestaltung der Erfindung wird als Targetelektrode ein Magnetron, in das die für den Zerstäubungsprozeß erforderliche HF-Leistung eingespeist wird, eingesetzt. Ein Magnetron bewirkt, daß das Plasma in Targetnähe konzentriert und damit der Ionenbeschuß der wachsenden Schicht drastisch vermindert wird, so daß z.B. keine das epitaxiale Wachstum beeinträchtigenden Rückzerstäubungseffekte an der Schicht auftreten. Mit der Anwendung eines Magnetrons ist darüberhinaus der Vorteil verbunden, daß der Abstand zwischen Target und Substrat im Vergleich zu Verfahren, die mit HF-Kathodenzerstäubungsanlagen in Diodenanordnung arbeiten, optimiert werden kann im Sinne einer möglichst geringen Plasmadichte in der Nähe des Substrates bei einer möglichst hohen Abscheidungsrate.

Nach einer weiteren vorteilhaften Ausgestaltung der Erfindung wird das Substrat während des Epitaxieprozesses auf eine Temperatur von $\approx$ 450°C aufgeheizt. Wie oben bereits beschrieben, ergibt sich oberhalb dieser Temperatur die Möglichkeit, auf einem in seiner Gitterstruktur örtlich gestörten einkristallinen Granatsubstrat eine Schicht abzuscheiden, die aus Bereichen unterschiedlicher Ordnung, nämlich amorphen Schichtbereichen und epitaxialen Granatschichtbereichen besteht. Die zu wählende Substrattemperatur ist dabei abhängig von der gewünschten Zusammensetzung der herzustellenden Schicht und muß empirisch ermittelt werden.

Insbesondere bei der Herstellung magneto-optischer Schichten ergeben sich bei Anwendung des vorliegenden Verfahrens besondere Vorteile : magneto-optische ferrimagnetische Granatschichten auf nicht-magnetischen Granatsubstraten müssen bislang durch ein naßchemisches Ätzverfahren in einzelne, voneinander getrennte magneto-optische Inseln auf dem Substrat unterteilt (= strukturiert) werden, wenn sie z.B. für den Aufbau magnetooptischer Lichtschaltelemente eingesetzt werden sollen. In der Praxis dürfen derartige magneto-optische Inseln nur eine Kantenlänge von maximal 100 µm haben, um sicher jeweils Bereiche einheitlicher Magnetisierungsrichtung zu haben. Solche reproduzierbar genaue Strukturierung einer Schicht mit Hilfe eines naßchemischen Ätzprozesses stellt hohe Anforderungen an die Maskentechnik und es ist z.B. schwierig, Unterätzung zu vermeiden.

Mit dem vorliegenden Verfahren können nun z.B. epitaxiale Inseln erzeugt werden, die jeweils in Material derselben chemischen Zusammensetzung und vergleichbarer Homogenität, jedoch einer von den Inseln abweichenden Ordnung eingebettet sind.

Die die epitaxialen Inseln umgebenden Randzonen sind amorph und haben eine glatte Oberfläche, wobei die Grenzflächen (interfaces) zwischen den einkristallinen Inseln und den amorphen Randzonen sehr steil und glatt sind.

Ein anderer Vorteil der nach dem vorliegenden Verfahren hergestellten Schichten ist, daß weitere, gegebenenfalls strukturierte Schichten auf einer ersten strukturierten epitaxialen Schicht ohne Probleme hinsichtlich der Bedeckung von Kanten angebracht werden können, weil die erste Schicht trotz ihrer Strukturierung quasi planar vorliegt. Dies ist z.B. von Vorteil bei der Herstellung von integrierten Halbleiterstrukturen und auch von Leiterbahnen.

Ein weiterer Vorteil der nach dem vorliegenden Verfahren hergestellten strukturierten epitaxialen Schichten liegt in der guten lateralen geometrischen Auflösung der hergestellten Strukturen : sie liegt in der Größenordnung der Schichtdicke.

Ein anderer Vorteil des vorliegenden Verfahrens ist, daß zur Herstellung der strukturierten epitaxialen Schichten mit einer einzigen Vorrichtung, nämlich der Kathodenzerstäubungsanlage, sowohl für die Vorbereitung der zu beschichtenden Substrate (Ionenbeschuß) als auch für die Herstellung der epitaxialen Schicht gearbeitet werden kann, was für einen Fertigungsprozeß von wirtschaftlicher Bedeutung ist.

Ein weiterer Vorteil des vorliegenden Verfahrens ist, daß sehr dünne homogene epitaxiale Schichten herstellbar sind, weil keine transient-d.h. Übergangs-Schichten, wie sie bei der Flüssigphasenepitaxie auftreten, gebildet werden.

Vorteilhaft beim vorliegenden Verfahren ist z.B. für die Herstellung von ferrimagnetischen Granatschichten auf einem nicht-magnetischen Substrat auch, daß die Anpassung der Gitterkonstanten von Substrat und Schicht geringere Probleme bereitet, als z.B. bei der Flüssigphasenepitaxie ; Gitterfehlanpassungen von > 1% sind tolerierbar.

Für die HF-Kathodenzerstäubung können im Handel erhältliche, mit HF-Spannung zu betreibende Kathodenzerstäubungsanlagen mit einer magnetischen Targetelektrode (Magnetron) benutzt werden, wobei als Hilfsvorrichtung eine Meßvorrichtung zur Messung der effektiven HF-Spannung sowohl an der Targetelektrode als auch an der Substratelektrode vorzusehen ist. Die Magnetronelektrode ist liegend in einen herkömmlichen Vakuumrecipienten eingebaut. Die für den Zerstäubungsprozeß erforderliche HF-Leistung wird über Impedanzanpassungsglieder sowie über die Targetelektrode und die Substratelektrode dem Plasma zugeführt. Die Konstanthaltung der HF-Spannung an der Targetelektrode auf Werte besser als ± 1% wird über eine Rechnersteuerung erreicht. Ebenfalls wird der Druck des Plasmagases durch Rechnersteuerung auf ± 1% konstant gehalten. Als Energiequelle für die Zerstäubungseinrichtung dient ein normaler HF-Generator, der bei einer Ausgangsleistung von 200 W betrieben wird. Die Betriebsfrequenz liegt bei 13,56 MHz.

Als Ausführungsbeispiel der Erfindung wird die Herstellung von strukturierten epitaxialen Wismut-substituierten Gadolinium-Eisen-Granat-Schichten, bei denen ein Teil des Eisens durch Aluminium und Gallium substituiert ist, beschrieben.

Als Substrate wurden in (111)-Richtung orientierte Calcium-Magnesium-Zirkonium-substituierte Gadolinium-Gallium-Granat-Einkristallscheiben eines Durchmessers von 30 mm verwendet.

Um in derartigen Substraten Gitterstörungen in Bereichen, auf denen die nachfolgend aufzubringende Schicht nichteinkristallin aufwachsen soll, zu erzeugen, werden die Substrate zunächst durch einen naßchemischen Ätzprozeß in Phosphorsäure von 150°C über eine Dauer von 20 s geätzt, in deionisiertem fließendem Wasser gespült und zentrifugiert. Anschließend werden die Substrate etwa 30 min bei einer Temperatur ausgeheizt, die der späteren Abscheidungstemperatur entspricht. Anschließend werden die Substrate mit einer photolithographischen Maske an den Stellen, die in ihrer Gitterstruktur nicht gestört werden sollen, versehen.

Das so vorbereitete Substrat wird auf der Targetelektrode der ebenfalls für den nachfolgenden Kathodenzerstäubungsprozeß einzusetzenden Kathodenzerstäubungsanlage deponiert und einem Ionenbeschuß mittels eines Argonplasmas ausgesetzt, wobei der Druck der Argonatmosphäre 0,2 Pa und die Ionenenergie $10^2$ eV betragen. Der Ionenbeschuß wird über eine Dauer von 10 min durchgeführt, wobei die ersten Atomlagen des Substratgitters so gestört werden, daß bei dem nachfolgenden epitaxialen Beschichtungsprozeß einkristalline Schichten in diesen Bereichen nicht aufwachsen. In den gestörten Substratbereichen wachsen die Schichten vorzugsweise amorph auf. Das mittels Ionenbeschuß gestörte Kristallgitter der Substrate heilt bei Temperaturen bis zu 800°C nicht aus. Ebenso erfolgt auch keine Rekristallisation amorpher Eisen-Granat-Schichten bei Temperaturen < 700°C. Daraus folgt, daß der Zustand der amorphen Schichtbereiche während der Abscheidung sehr stabil ist. Nach dem Ionenbeschuß werden die Substrate aus der Kathodenzerstäubungsanlage herausgenommen und die Photolackmaske wird entfernt.

Anschließend werden die Substrate auf der Substratelektrode befestigt.

Als Target (kathodische Zerstäubungsquelle) dient ein durch Heißpressen aus Mischoxiden der am Schichtaufbau beteiligten Elemente hergestellter Körper eines Durchmessers von 7,5 cm einer Dicke von 4 mm und einer Porosität von <10%.

Für die nachfolgenden Ausführungsbeispiele werden Pulvergemische aus $BiFeO_3$, $Gd_2Bi_1Fe_5O_{12}$, $Al_2O_3$ und $Ga_2O_3$ in Sauerstoffatmosphäre eines Drucks von 1 bar über eine Dauer von 6 Stunden bei einer Temperatur < 920°C gesintert, wobei der Prozeß so geführt wird, daß kein freies $Bi_2O_3$ im Keramikgefüge zurückbleibt. Freies $Bi_2O_3$ soll deswegen nicht im Target vorhanden sein, da es zur mechanischen Desintegration der Oberfläche des Targets durch seine gegenüber den anderen Targetbestandteilen erhöhte Zerstäubungsrate führt; durch die Verwendung von Mischoxiden wird eine Homogenisierung der Zerstäubungsrate aller Phasenbestandteile des Targets erreicht.

## Beispiel 1

Zur Herstellung einer epitaxialen einphasigen Granatschicht der Zusammensetzung $Gd_{1,90}Bi_{1,45}Fe_{4,09}Al_{0,34}Ga_{0,22}O_{12}$ wird ein Target eines Durchmessers von 7,5 cm folgender Zusammensetzung verwendet (Angaben in Gew.%) :

| | |
|---|---|
| $Gd_2O_3$ | 33,64 |
| $Bi_2O_3$ | 31,80 |
| $Fe_2O_3$ | 31,52 |
| $Al_2O_3$ | 1,15 |
| $Ga_2O_3$ | 1,89 |

Der Targetkörper wird auf der Targetelektrode mit einem gut wärmeleitfähigen Kleber (z.B. mit Silberpulver gefülltes Epoxidharz) befestigt.

Um Verlustwärme abzuführen, ist es zweckmäßig, z.B. durch Wasser gekühlte Targetelektroden zu verwenden.

Der Beschichtungsprozeß wird so durchgeführt, daß die Zerstäubungsapparatur zunächst mit einer Vakuumpumpe bis zu einem Druck von < $10^{-5}$ mbar evakuiert wird, anschließend wird ein Edelgas, vorzugsweise Argon eines Drucks von 0,6 Pa eingeleitet. Der Abstand zwischen Target und Substrat beträgt 80 mm. Die Niederschlagsrate liegt bei etwa 0,8 µm/h. Die an der HF-Zuleitung an der Rückseite der Targetelektrode gemessene HF-Spannung beträgt 230 $V_{eff}$, die Substratspannung ist schwebend. Die Substrattemperatur beträgt 480°C.

## Beispiel 2

Zur Herstellung einer epitaxialen einphasigen Granatschicht der Zusammensetzung $Gd_{1,97}Bi_{1,04}Fe_{4,51}Ga_{0,22}Al_{0,26}O_{12}$ wird ein Target eines Durchmessers von 7,5 cm mit folgender Zusammensetzung verwendet (Angaben in Gew.%) :

| | |
|---|---|
| $Gd_2O_3$ | 36,514 |
| $Bi_2O_3$ | 24,122 |
| $Fe_2O_3$ | 36,074 |
| $Al_2O_3$ | 1,220 |
| $Ga_2O_3$ | 2,070 |

Der Targetkörper wird auf der Targetelektrode, wie zu Beispiel 1 beschrieben, befestigt.

Es ist ebenfalls zweckmäßig, um Verlustwärme abzuführen, durch Wasser gekühlte Targetelektroden zu verwenden.

Der Beschichtungsprozeß wird wie zu Beispiel 1 beschrieben durchgeführt, die Substrattemperatur betrug jedoch 535°C.

Vor der Abscheidung der Schichten (typische Schichtdicken liegen bei 1 bis 5 μm) wird das Target durch Zerstäuben im Plasma solange angeätzt, bis sich eine konstante Zusammensetzung des abgestäubten Targetmaterials eingestellt hat.

Die Vorätzzeit reduziert sich bei weiteren Experimenten mit ein und demselben Target auf etwa 0,5 h bis auf einige 10 min, bis sich am Target das Gleichgewichtspotential stabilisiert hat.

Nach Abscheiden in der Kathodenzerstäubungsanlage werden Schichten erhalten, die auf den Substratbereichen mit einer Gitterfehlordnung amorph bzw. röntgenamorph und auf den Substratbereichen mit einkristallinem, ungestörtem Kristallgitter einkristallin sind. Am Beispiel der auf diese Weise hergestellten Wismut-substituierten Eisen-Granat-Schichten wurden folgende Eigenschaften der mit dem vorliegenden Verfahren strukturierten Schichten verifiziert :

– Die Randzone um die epitaxialen, also einkristallinen Bereiche ist glatt.

– Magnetische Domänen schließen sich übergangslos gut an die amorphen Randzonen an unter Ausbildung eines relativ scharfen Überganges zwischen paramagnetischen und ferrimagnetischen Schichtbereichen.

– Die geometrische laterale Auflösung der nach dem vorliegenden Verfahren erhaltenen Struktur ist in der Größenordnung der Schichtdicke.

– Bis auf eine Stufe von etwa 10% der Schichtdicke zwischen amorphen und einkristallinen Schichtbereichen, die eine Folge der unterschiedlichen Wachstumsraten des einkristallinen und des amorphen Schichtmaterials ist, ist die Struktur der erhaltenen Schichten planar. Unter Berücksichtigung der zwischen den amorphen und einkristallinen Schichtbereichen vorliegenden geringen Stufe kann also von einer insgesamt quasi planaren Struktur gesprochen werden.

– Die amorphen wie auch die einkristallinen Schichtbereiche sind in bezug auf ihre Dicke, ihre chemische Zusammensetzung und ihre Oberflächenbeschaffenheit äußerst homogen.

– Die amorphen Schichtbereiche zeigen im Gegensatz zu den einkristallinen Schichtbereichen keine spontane Magnetisierung (sie sind paramagnetisch).

– Die erhaltenen Schichten sind im Sinne der Stöchiometrie sauerstoffgesättigt, auch wenn sie in einem nicht sauerstoffhaltigen Plasma aufgestäubt wurden.

– Edelgasatome werden in spontan kristallisierte Schichten nur in Mengen << 0,1% eingebaut.

## Patentansprüche

1. Verfahren zur Herstellung von strukturierten epitaxialen Schichten, bei denen einkristalline Schichtbereiche benachbart neben Schichtbereichen anderer Ordnung auf einem einkristallinen Substrat vorhanden sind, dessen Kristallgitter in örtlich begrenzten Oberflächenbereichen unter Ausbildung einer Gitterfehlordnung gestört ist,
dadurch gekennzeichnet,
daß die Schichten mittels HF-Kathodenzerstäubung (Sputterepitaxie) in einem Inertgasplasma unter Verwendung eines die am Schichtaufbau beteiligten Elemente in Form von Phasen mit nahezu gleicher Zerstäubungsrate enthaltenden Targets hergestellt werden, wobei das Substrat auf eine Temperatur aufgeheizt wird, die höher ist, als die Temperatur, bei der epitaxiales Schichtwachstum auf Substratbereichen mit ungestörtem Kristallgitter beginnt, und die niedriger ist, als die Temperatur, bei der polykristallines Schichtwachstum auf Substratbereichen mit gestörtem Kristallgitter beginnt und wobei die Gitterstruktur des Substrates bis in einige Atomlagen Tiefe durch Ionenbeschuß mittels eines Plasmas örtlich gestört wird.

2. Verfahren nach Anspruch 1,
dadurch gekennzeichnet,
daß das HF-Kathodenzerstäubungsverfahren in einem Edelgasplasma durchgeführt wird.

3. Verfahren nach den Ansprüchen 1 und 2,
dadurch gekennzeichnet,
daß strukturierte einkristalline ferrimagnetische Granatschichten der allgemeinen Formel $(A,B)_3(A,B)_5O_{12}$ hergestellt werden mit
A = mindestens ein Seltenerdmetall, Bi und/oder Ca
B = Ga,Al,Fe,Co,Ni,Mn,Ru,Ir,In und/oder Sc.

4. Verfahren nach Anspruch 3,
dadurch gekennzeichnet,
daß Schichten mit einer Zusammensetzung entsprechend der Formel
$Gd_{1,90}Bi_{1,45}Fe_{4,09}Al_{0,34}Ga_{0,22}O_{12}$

hergestellt werden.

5. Verfahren nach Anspruch 3,

dadurch gekennzeichnet,

daß Schichten mit einer Zusammensetzung entsprechend der Formel

$Gd_{1,97}Bi_{1,04}Fe_{4,51}Ga_{0,22}Al_{0,26}O_{12}$

hergestellt werden.

6. Verfahren nach mindestens einem der vorhergehenden Ansprüche,

dadurch gekennzeichnet,

daß als Targetelektrode ein Magnetron, in das für die den Zerstäubungsprozeß erforderliche HF-Leistung eingespeist wird, eingesetzt wird.

7. Verfahren nach mindestens einem der vorhergehenden Ansprüche,

dadurch gekennzeichnet,

daß als Substrat eine in (111)-Richtung orientierte nichtmagnetische Granat-Einkristallscheibe eingesetzt wird.

8. Verfahren nach Anspruch 7,

dadurch gekennzeichnet,

daß als Substrat

Calcium-Magnesium-Zirkonium-substituierter Gadolinium-Gallium-Granat $(Gd,Ca)_3(Ga,Mg,Zr)_5O_{12}$ eingesetzt wird.

9. Verfahren nach mindestens einem der vorhergehenden Ansprüche,

dadurch gekennzeichnet,

daß das Substrat zur Herstellung einer örtlich gestörten Gitterstruktur mit einer Photolackmaske an den Stellen, deren Gitterstruktur nicht gestört werden soll, versehen wird, daß das Substrat einem Ionenbeschuß in einem Edelgasplasma eines Drucks von 0,1 bis 1 Pa bei einer Ionenenergie > 30 eV unterzogen wird.

10. Verfahren nach den Ansprüchen 7 bis 9,

dadurch gekennzeichnet,

daß der Ionenbeschuß in einem Argonplasma eines Drucks von 0,2 Pa bei einer Ionenenergie von $10^2$ eV durchgeführt wird.

11. Verfahren nach mindestens einem der vorhergehenden Ansprüche,

dadurch gekennzeichnet,

daß das Substrat während des Epitaxieprozesses auf eine Temperatur von ≈ 450 °C aufgeheizt wird.

12. Verwendung der nach dem Verfahren der Ansprüche 3 bis 11 hergestellten ferrimagnetischen Granatschichten in magneto-optischen Displays.

13. Verwendung der nach dem Verfahren der Ansprüche 3 bis 11 hergestellten ferrimagnetischen Granatschichten in Zylinderdomänenspeichern.

14. Verwendung der nach dem Verfahren der Anspüche 3 bis 11 hergestellten ferrimagnetischen Granatschichten für magneto-optische Lichtschaltelemente.

## Claims

1. A method of manufacturing structured epitaxial layers, comprising monocrystalline layer regions which are situated adjacent to layer regions of a different order on a monocrystalline substrate whose crystal lattice is disturbed in locally bounded surface regions, thereby forming a lattice disorder,

characterized in that

the layers are manufactured by means of RF cathode sputtering (sputter epitaxy) in an inert gas plasma, making use of a target which contains the elements which contribute, in the form of phases with an almost identical sputtering rate, to the formation of the layer, the substrate being heated to a temperature which is higher than the temperature at which epitaxial layer growth starts on substrate regions having an undisturbed crystal lattice, and which is lower than the temperature at which polycrystalline layer growth starts on substrate regions having a disturbed crystal lattice, and the lattice structure of the substrate being locally disturbed to a depth of several atom layers by ion bombardment using a plasma.

2. A method as claimed in Claim 1,

characterized in that

the RF cathode sputtering process is carried out in a helium-group gas plasma.

3. A method as claimed in Claims 1 and 2,

characterized in that

structured monocrystalline ferrimagnetic garnet layers of the general formula $(A,B)_3 (A,B)_5O_{12}$ are manufactured, where

A = at least one rare earth metal, Bi and/or Ca ;
B = Ga, Al, Fe, Co, Ni, Mn, Ru, Ir, In,and/or Sc.

4. A method as claimed in Claim 3,
characterized in that
layers are manufactured whose composition corresponds to the formula
$Gd_{1,90}Bi_{1,45}Fe_{4,09}Al_{0,34}Ga_{0,22}O_{12}$.

5. A method as claimed in Claim 3,
characterized in that
layers are manufactured whose composition corresponds to the formula $Gd_{1,97}Bi_{1,04}Fe_{4,51}Ga_{0,22}Al_{0,26}O_{12}$.

6. A method as claimed in at least one of the preceding Claims,
characterized in that
a magnetron is used as the target electrode, to which the RF power which is necessary for the sputtering process is applied.

7. A method as claimed in at least one of the preceding Claims,
characterized in that
a (111)-oriented, non-magnetic, single-crystal garnet disc is used as the substrate.

8. A method as claimed in Claim 7,
characterized in that
calcium-magnesium-zirconium-substituted gadolinium gallium garnet $(Gd,Ca)_3(Ga,Mg,Zr)_5O_{12}$ is used as the substrate.

9. A method as claimed in at least one of the preceding Claims,
characterized in that
for the manufacture of a locally disturbed lattice structure, the substrate is provided with a photoresist mask at the areas whose lattice structure is not to be disturbed, in that the substrate is subjected to an ion bombardment in a helium-group gas plasma having a pressure of 0.1 to 1 Pa at an ion energy > 30 eV.

10. A method as claimed in Claims 7 to 9,
characterized in that
the ion bombardment is carried out in an argon plasma having a pressure of 0.2 Pa at an ion energy of $10^2$ eV.

11. A method as claimed in at least one of the preceding Claims,
characterized in that
in the epitaxy process the substrate is heated to a temperature of $\approx 450°C$.

12. The use of ferrimagnetic garnet layers, manufactured in accordance with the method as claimed in Claims 3 to 11, in magneto-optical displays.

13. The use of ferrimagnetic garnet layers, manufactured in accordance with the method as claimed in Claims 3 to 11, in cylindrical domain memories.

14. The use of ferrimagnetic garnet layers, manufactured in accordance with the method as claimed in Claims 3 to 11, for magneto-optical light switching elements.

**Revendications**

1. Procédé pour la fabrication de couches épitaxiales structurées dans lesquelles des domaines de couche monocristallins sont présents à côté de domaines de couche d'un autre arrangement sur un substrat monocristallin dont le réseau cristallin est perturbé dans des domaines superficiels localement limités avec formation d'un arrangement erroné du réseau,
caractérisé en ce que
les couches sont fabriquées par pulvérisation cathodique haute fréquence (épitaxie par pulvérisation) dans un plasma de gaz inerte avec utilisation d'un des éléments participant à la formation de la couche sous forme de phases avec des cibles présentant pratiquement le même taux de pulvérisation, le substrat est chauffé à une température qui est supérieure à la température à laquelle commence la croissance de couche épitaxiale sur des domaines de substrat présentant un réseau cristallin non perturbé et qui est inférieure à la température à laquelle commence la croissance de couche polycristalline sur des domaines de substrat présentant un réseau cristallin perturbé et la structure de réseau du substrat est perturbé localement jusqu'à une profondeur de quelques couches d'atome par un bombardement ionique à l'aide d'un plasma.

2. Procédé selon la revendication 1,
caractérisé en ce que
le procédé de pulvérisation cathodique haute fréquence s'effectue dans un plasma de gaz inerte.

3. Procédé selon les revendications 1 et 2,

caractérisé par

la fabrication de couches de grenat ferrimagnétiques monocristallines structurées répondant à la formule générale $(A,B)_3(A,B)_5O_{12}$,

A étant au moins un métal des terres rares, Bi et/ou Ca et

B étant Ga, Al, Fe, Co, Ni, Mn, Ru, Ir, In et/ou Sc.

4. Procédé selon la revendication 3,

caractérisé par

la fabrication de couches présentant une composition répondant à la formule

$Gd_{1,90}Bi_{1,45}Fe_{4,09}Al_{0,34}Ga_{0,22}O_{12}$.

5. Procédé selon la revendication 3,

caractérisé par

la fabrication de couches présentant une composition répondant à la formule

$Gd_{1,97}Bi_{1,04}Fe_{4,51}Ga_{0,22}Al_{0,26}O_{12}$.

6. Procédé selon au moins l'une des revendications précédentes,

caractérisé en ce qu'un

magnétron dans lequel est introduit la puissance haute fréquence nécessaire pour le processus de pulvérisation est utilisé comme électrode de cible.

7. Procédé selon au moins l'une des revendications précédentes,

caractérisé en ce qu'un

disque monocristallin de grenat non magnétique orienté dans la direction (111) est utilisé comme substrat.

8. Procédé selon la revendication 7,

caractérisé par

l'utilisation de grenat de gadolinium-gallium substitué par du calcium-magnésium-zirconium $(Gd, Ca)_3(Ga, Mg, Zr)_5O_{12}$ comme substrat.

9. Procédé selon au moins l'une des revendications précédentes,

caractérisé en ce que

pour la fabrication d'une structure de réseau localement perturbée le substrat est muni d'un masque en vernis photosensible aux endroits dont la structure de réseau ne doit pas être perturbée et le substrat est exposé à un bombardement ionique dans un plasma de gaz inerte d'une pression de 0,1 à 1 Pa à une énergie d'ions > 30 eV.

10. Procédé selon les revendications 7 à 9,

caractérisé en ce que

le bombardement ionique s'effectue dans un plasma d'argon d'une pression de 0,2 Pa à une énergie d'ions $10^2$ eV.

11. Procédé selon au moins l'une des revendications précédentes,

caractérisé en ce que

lors du processus d'épitaxie, le substrat est chauffé à une température d'environ 450°C.

12. Application des couches de grenat ferrimagnétiques réalisées conformément au Procédé selon les revendications 3 à 11 dans des dispositifs d'affichage magnéto-optiques.

13. Application des couches de grenat ferrimagnétiques réalisées conformément au procédé selon les revendications 3 à 11 dans des mémoires à domaine cylindrique.

14. Application des couches de grenat ferrimagnétiques réalisées conformément au procédé selon les revendications 3 à 11 aux éléments de circuit d'éclairage magnéto-optique.